(19) Europäisches Patentamt
European Patent Office
Office européen des brevets

(11) EP 0 399 601 B1

## (12) EUROPEAN PATENT SPECIFICATION

(45) Date of publication and mention
of the grant of the patent:
**03.04.1996 Bulletin 1996/14**

(51) Int Cl.6: **H04N 5/217**, G11C 27/04,
H01L 27/14

(21) Application number: **90201249.1**

(22) Date of filing: **17.05.1990**

(54) **Dark current reduction in buried channel charge coupled imaging device**

Dunkelstromverminderung in einer ladungsgekoppelten Bildaufnahmevorrichtung mit vergrabenem Kanal

Réduction du courant d'obscurité dans un dispositif capteur d'images à couplage de charges à canal enterré

(84) Designated Contracting States:
AT CH DE FR GB IT LI NL

(30) Priority: **23.05.1989 NL 8901283**

(43) Date of publication of application:
**28.11.1990 Bulletin 1990/48**

(73) Proprietor: **Philips Electronics N.V.**
NL-5621 BA Eindhoven (NL)

(72) Inventor: **Stekelenburg, Michael Alwin William**
NL-5656 AA Eindhoven (NL)

(74) Representative:
**Houbiers, Ernest Emile Marie Gerlach et al**
**INTERNATIONAAL OCTROOIBUREAU B.V.,**
**Prof. Holstlaan 6**
**NL-5656 AA Eindhoven (NL)**

(56) References cited:
**EP-A- 0 247 503**

- **IEEE TRANSACTIONS ON NUCLEAR SCIENCE,
vol. NS-27, no. 6, December 1980,
pages 1727-1734; N.S. SAKS: "A new technique
for hardening CCD imagers by suppression of
interface state generation"**
- **"television engineering handbook", I.Benson,
K.Blair. Chapter 11.8 "Solid state imager
development" pages 11.60-11.63, published
1986 by McGraw-Hill.**

## Description

The invention relates to a method of operating a charge coupled image sensor of the buried channel type, comprising a semiconductor body having a plurality of charge transport channels of the one conductivity type which are located beside each other and near a surface of the body and pass via pn junctions into an adjoining layer of the second conductivity type, opposite to the first conductivity type, a series of electrodes being provided which are separated from the surface by an isolating layer, said channels forming together with the electrodes a system of image sensor elements arranged in lines and columns, a charge storage site of said sensor elements being determined by voltages which are applied to the electrodes and which induce in the channels a pattern of potential barriers separating potential wells in which during a integration period, charge carriers, generated by absorption of radiation, are integrated to charge packets, said voltages being chosen so that at the potential barriers inversion of the conductivity type occurs at the surface of the semiconductor body.

A charge-coupled device of the kind described in the opening paragraph is known inter alia from the article by N.J. Saks "A Technique for Suppressing Dark Current Generated by Interface States in Buried Channel CCD imagers", published in I.E.E.E. Electron Device Letters, Vol. ED-1, No. 7 (July 1980), pp. 131/133.

In charge-coupled devices, the leakage current or dark current is kept as low as possible. With the use of the device, for example, as a memory, the leakage current determines to a great extent the maximum storage time. In charge-coupled image sensor arrangements, the sensitivity is limited to a considerable extent by the dark current of the CCD. In general, as is known, a large part of the dark current is caused by surface states in the forbidden energy band. These states are used by the electrons as intermediate station when passing from the valency band to the conduction band. A considerable reduction of the dark current in CCD's can be attained in that these surface states are freed via recombination with holes from electrons before they have made the second step to the conduction band. A method suitable for this purpose consists in bringing the surface into inversion, as a result of which this surface is overflown with holes, as described in the aforementioned publication. This known arrangement is a CCD image sensor, in which during the integration period such a voltage is applied to the electrodes that the whole surface of the transport channel is in inversion. A disadvantage is that also the semiconductor surface below the integrating electrodes is in inversion. The charge separating function of the electrodes - usually by application of different voltages to the electrodes - is practically entirely eliminated due to the fact that the surface potential is practically entirely determined by the potential in the inversion layer. As already indicated in the publication, the separation between the successive charge packets should then be obtained in a different manner.

The invention has for its object to provide a charge-coupled device, in which the leakage current (dark current) can be kept low by means of recombination in an inversion layer and in which at the same time the charge separation can be realized in a usual manner, more particularly by means of suitable potential differences between the electrodes. This object is achieved by the invention set out in claim 1.

A charge-coupled device according to the invention is characterized in that the active level is chosen so that depletion occurs only at the surface, while during operation the surface parts of the charge transport channel corresponding to at least a part of the said electrodes are alternately brought into depletion, in which event signal charge can be stored below the electrodes, and into inversion.

In the device acccording to the invention, the part of the charge transport channel in which charge is stored is not permanently, but only periodically brought into inversion. The fact is then utilized that dark current generation via surface states (traps) is a process in which time constants play an important part. When the period in which a surface part is not in inversion, while information is stored in the associated part of the channel, is chosen sufficiently short, it can be avoided that an excessive quantity of traps are filled from the valency band with electrons and thus cause dark current. Although the overall dark current can be slightly larger than in the situation in which the whole surface of the channel is permanently brought into inversion, it has been found in practice that it is possible to keep the dark current very low in an arrangement according to the invention. At the same time, the charge can be stored in a comparatively deep potential well due to the local absence of an inversion layer, as a result of which successive charge packets can be satisfactorily separated from each other.

The invention can advantageously be used in each CCD system, such as memory filters, signal processors, multiplex circuits and the like. Particular advantages are obtained in CCD image sensors, in which charge packets are stored during about a frame period of 20 m.sec of a T.V. system in a storage site.

An important preferred embodiment, in which cross-talk from the clock signal to the output signal is avoided as far as possible, is characterized in that in the period in which a charge packet is stored in the said charge storage site the voltages at the inner electrodes of this storage site are periodically varied in the period coinciding with the line fly-back time lying between the steps of reading out two successive lines.

The invention will be described more fully with reference to an embodiment and the accompanying diagrammatic drawing, in which:

Figure 1 shows the diagram of a CCD sensor of the FT type, in which the invention is used;
Figure 2 is a longitudinal sectional view of one of the CCD registers in the sensor section of the arrangement of Figure 1;

Figure 3 shows the clock voltages $\phi_1$, $\phi_2$, $\phi_3$ and $\phi_4$ applied to the arrangement shown in Figure 1 as a function of the time $t$;

Figure 4 shows the potential profiles in the CCD channel at these clock voltages at four instants;

Figure 5 shows the band diagram of silicon;

Figure 6 shows the reduction of the leakage current as a function of the applied voltage.

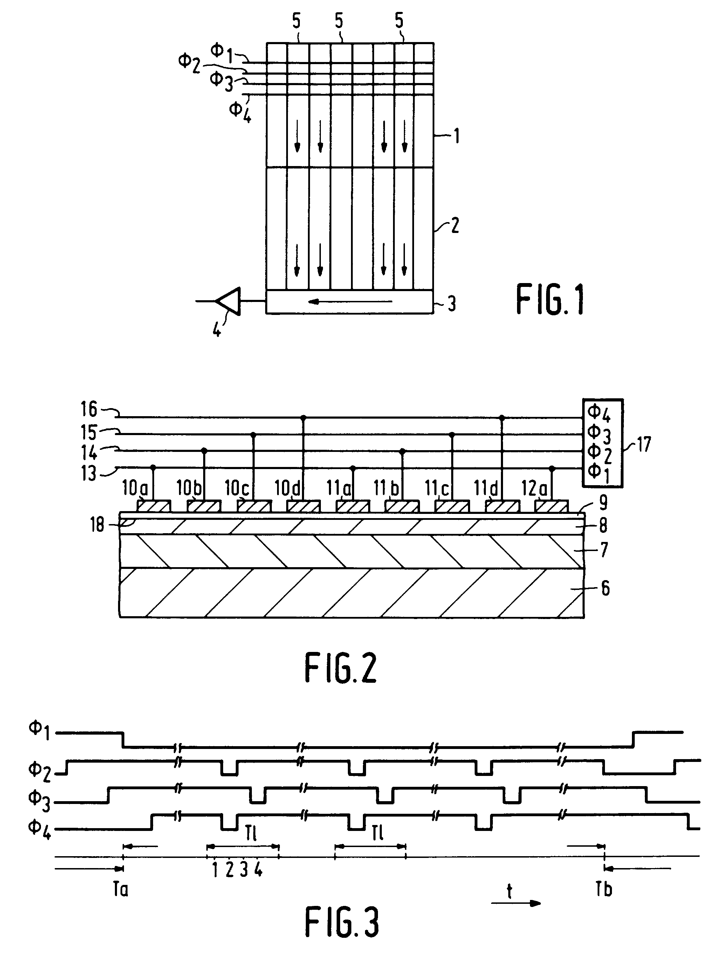

It should be noted that the drawings of Figures 1 and 2 are schematic and not to scale. It should be noted more particularly that, although in the diagram of Figure 1 only eight parallel channels 5 are shown, this number will actually be considerably larger.

The invention will be described more fully with reference to a charge-coupled image sensor of the frame transfer type (FT). However, it should always be taken into account that the invention is not limited to the use in FT sensors, but can be used in any charge-coupled device with buried channel. Figure 1 shows the known diagram of an FT sensor comprising an image sensor section 1, a memory section 2 and the horizontal read-out register 3, whose output is connected to an output amplifier 4. The sensor section 1 and the memory section 2 are constituted by a mat of charge transport registers 5, the upper part, which constitutes the sensor section 1 onto which the image to be sensed is projected, being accessible for radiation. The sections 2 and 3 are mostly made inaccessible for radiation, for example by means of an Al layer covering the surface of these sections. The charge transport takes place by applying clock voltages to clock electrodes, which are arranged above the sensor section 1, the memory section 2 and the horizontal read-out register 3. In Figure 1, only four of the electrodes are shown with the associated clock voltages $\phi_1$, $\phi_2$, $\phi_3$ and $\phi_4$.

Figure 2 is a sectional view of the arrangement along part of a charge transport channel in the image sensor section, the charge transport taking place from the left to the right. The arrangement comprises an n-type substrate 6, which serves as a drain for generated charge carriers in the case of over-exposure. For this aspect, reference may be made to Netherlands Patent Application "Blooming-insensitive image sensor arrangement and method of manufacturing it", which has been filed in the name of the Applicant under Application No. 8304035 on 24 November 1983 and has been laid open to public inspection on 17 June 1985. The n-type substrate 6 is provided at its surface with a comparatively thin p-type layer 7, which separates the n-type substrate 6 from the n-type surface layer 8 which constitutes one of the vertical CCD channels 5. The clock electrodes 10a, 10b, 10c, 10d, 11a, 11b, 11c etc. are arranged above the surface so as to be separated therefrom by the gate dielectric 9. In the drawing, the electrodes are shown one beside the other for the sake of clarity. Actually, however, the electrodes will overlap each other in part in the form of a multilayer wiring system. The electrodes are connected through the clock lines 13, 14, 15 and 16 to the voltage source 17, which supplies the clock voltages $\phi_1$, $\phi_2$, $\phi_3$ and $\phi_4$. It should be noted that the present arrangement constitutes a 4-phase CCD. It will appear from the following, however, that this is not necessary at all, but that also in any other known n-phase CCD system the invention may be used. The clock voltages $\phi_1$, $\phi_2$, $\phi_3$ and $\phi_4$, which are shown in Figure 3 as a function of the time $t$, have two levels, i.e. a low level at which a potential barrier is induced in the layer 8 and a high level at which potential wells are induced below the electrodes, in which wells charge packets are stored. The low level is chosen so that at the interface 18 between the n-layer 8 and the dielectric layer 9 an inversion layer of positive holes is built up. According to the invention, the positive level of the clocks $\phi_1$ ... $\phi_4$ is chosen so that at this voltage the surface of the n-type layer 8 is not brought into inversion, but is at most depleted, that is to say that it is brought into a state in which no movable charge carriers are present at the surface. In order to avoid that too large a dark current generation occurs below the electrodes which are at the active voltage level, the voltage is varied so that the surface parts below these electrodes are alternately in depletion and in inversion.

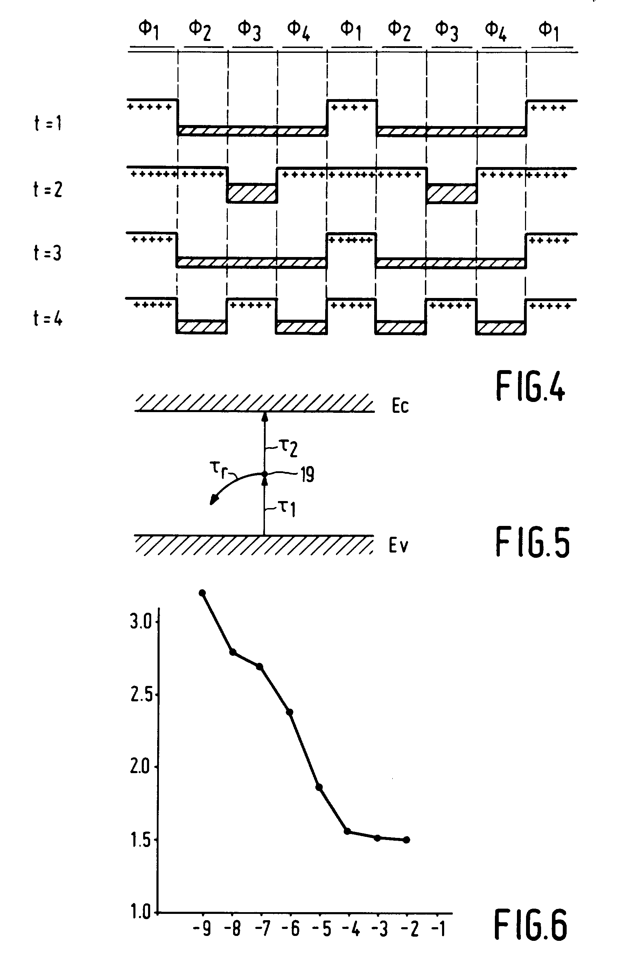

For the FT sensor described here, this means that in the image sensor section operated as a 4-phase CCD during the integration period in a series of five successive electrodes a charge storage site is limited by potential barriers below the first and fifth electrodes, for example in electrodes 10a, 11a. The voltage $\phi_1$ applied to the electrodes 10a, 11a is so low that below these electrodes inversion occurs. Alternating voltages varying between the active level and the blocking level are applied to the electrodes 10b, 10c, 10d, which during the integration period are at a D.C. voltage level during the integration period in conventional arrangements. As a result, the surface parts below these electrodes are periodically brought into inversion and into depletion. In order to avoid cross-talk to the output signal at the output 4, the voltages $\phi_2$, $\phi_3$ and $\phi_4$ are varied in the integration period only in the line fly-back time. The invention utilizes the fact that dark current generation is a process which is effected via traps and that time constants play an important part. In order to illustrate this, Figure 5 shows the band diagram of silicon. The lowest band of occupied energy levels is indicated by Ev (valency band) and the band of permitted states lying above it is indicated by Ec (conduction band). About halfway the forbidden band, a trap 19 is indicated. After the traps or at least the major part of the traps are emptied by an inversion layer, they will be filled again from the valency band with electrons with a time constant $\tau_1$. At the same time, a number of electrons will flow from the traps to the conduction band Ec. This happens with a time constant $\tau_2$. The state of equilibrium is attained with a time constant $\tau_3$, for which it holds that:

$$\frac{1}{\tau_3} = \frac{1}{\tau_1} + \frac{1}{\tau_2}$$

Since the traps are distributed over the whole forbidden energy band, an average must be taken for $\tau_3$. It has been found in practice that a value of at least about 100 μsec can be chosen therefor. The charge integration in each image sensor cell (pixel) is now split up into periods having a duration T, in which the electrodes cause alternately during a time Tinv an inversion layer and then are integrating during the time T-Tinv, <u>i.e.</u> induce a potential well. The time Tinv must be sufficiently long to cause a large number of electrons to recombine in the traps with holes from the inversion layer. The time constant $\tau$r with which this happens proves to be about 10 μsec or shorter. The time T-Tinv will preferably be chosen to be shorter or of the order of $\tau_3$ in order to avoid that too large a number of traps are filled again.

Figure 3 shows the clock diagram of $\phi_1$, $\phi_2$, $\phi_3$, $\phi_4$ as a function of the time <u>t</u>. In the period between Ta and Tb a trapped radiation pattern is converted in the image sensor section into a charge pattern. The period Ta-Tb is designated as the integration period. After the integration period, <u>i.e.</u> after Tb, the charge pattern formed is transported from the image sensor section to the memory section by means of 4-phase clocks. During the integration period, the image stored in the memory section is linewise read out <u>via</u> the horizontal read-out register 3. The period between two successive lines is designated as the line fly-back time and is indicated in Figure 3 by TI.

In the integration period, which begins at Ta, $\phi_1$ is adjusted to the blocking level, as a result of which a potential barrier, which insulates adjacent potential wells from each other, is induced below the electrodes 10a, 11a, 12a during the whole integration period. For illustration, for a number of instants Figure 4 shows the potential profile below a series of electrodes provided with the applied clocks $\phi_i$. The low level of the clocks is chosen so that inversion occurs below the electrodes, which is designated in Figure 4 by plus symbols, which indicate the presence of holes. The remaining electrodes <u>b</u>, <u>c</u> and <u>d</u> are adjusted to, for example, a 10 V higher level, as a result of which a potential well is induced below these electrodes without inversion; see Figure 4 at the instant $t_1$. In conventional arrangements, the voltages at the electrodes in the sensor section are not varied during the integration period. In order to avoid that too many traps are filled with electrons below the integrating gates, in the arrangement according to the invention the voltage at the integrating gates is varied periodically. For example, first $\phi_2$ and $\phi_4$ may be reduced by 10 V in voltage, while $\phi_3$ remains at the high level. This is indicated in Figure 4 by the instant $t_2$. The charge is fully compressed below $\phi_3$, while inversion now also occurs below the electrodes $\phi_2$ and $\phi_4$. This situation is maintained until all or at least substantially all electrons trapped in the local traps are recombined with holes from the inversion layer. Subsequently, $\phi_2$ and $\phi_4$ are adjusted again to the high voltage level ($t_3$), after which ($t_4$) $\phi_4$ is reduced by 10 V. The region below the electrodes connected to $\phi_4$ is now brought into inversion, as a result of which also the surface states below these electrodes are emptied. $\phi_4$ then also returns to the high level, as a result of which the situation of $t_1$ is obtained again, which is maintained till the next line fly-back time $t_1$. Thus, the dark current generation <u>via</u> surface states can be considerably reduced in that different surface parts are brought into inversion alternately and periodically. The improvement is plotted in Figure 6 against the negative voltage at the electrodes upon inversion. According as the voltage decreases, as a result of which the concentration of holes in the inversion layer and hence the recombination of holes with trapped electrons increases, the dark current decreases. At a voltage of -9 V, which is a suitable value for operating the sensor, the dark current is reduced by about a factor 3.

In the 4-phase embodiment described here, three out of four electrodes are at the active high voltage level during the integration period. As a result, there is integrated under three out of four electrodes, which is favourable in connection with a highest possible photosensitivity. During the charge transport after the integration period, the charges are compressed below two electrodes or possibly even below one single electrode. The excess quantity of charge can flow away by means of vertical anti-blooming to the substrate 6 in conventional arrangements, the voltages not varying in the integration period. However, a part of the charge can then reach the surface and can be trapped there by traps, which may give rise to the so-called smear phenomenon due to the fact that they are released again only after some time during the transport. Due to the measure described here, in which the charge is regularly compressed during the integration period below two electrodes or one electrode, a possible excess quantity of charge carriers can be drained in time <u>via</u> the substrate, as a result of which the smear effect described above can be avoided.

It will be appreciated that the invention is not limited to the embodiment described here, but that within the scope of the invention many further variations are possible for those skilled in the art. For example, the negative pulses of $\phi_2$ and $\phi_4$ for obtaining an inversion layer may be applied one after the other instead of simultaneously. The invention may also be used in charge-coupled devices other than described here.

**Claims**

1.   A method of operating a charge coupled image sensor of the buried channel type, comprising a semiconductor body having a plurality of charge transport channels (5, 8) of the one conductivity type which are located beside each other and near a surface (18) of the body and pass <u>via</u> pn junctions into an adjoining layer (7) of the second conductivity type, opposite to the first conductivity type, a series of electrodes (10 - 12) being provided which are separated from the surface by an isolating layer (9), said channels forming together with the electrodes a system of image sensor elements arranged in lines and columns, a charge storage site of said sensor elements being determined by the voltages which are applied to the electrodes and which induce in the channels a pattern (Fig. 4) of potential barriers separating potential wells in which during a integration period (Ta-Tb) charge carriers, generated by absorption of radiation, are integrated to charge packets, said voltages being chosen so that at the potential barriers inversion of the conductivity type occurs at the surface of the semiconductor body, characterized in that during one integration period alternating voltages are applied to the electrodes corresponding to the charge storage sites so that, at a certain moment in the integration period, in each charge storage site, the surface partly is brought into depletion and partly into inversion.

2. A method as claimed in Claim 1, characterized in that voltages are supplied to the electrodes having two levels, a blocking level for inducing a potential barrier in the channels and an active level for inducing a potential well in the channels, the inversion of the conductivity type being induced at the blocking voltage level at the electrodes.

3. A method as claimed in Claim 2, wherein the electrodes comprise at least a group of n+1 successive electrodes (10a, b, c, d; 11a) with n > 3, which together define a charge sensor element in a charge transport channel, characterized in that during an integration period in which a charge packet is stored in said sensor element the blocking level is supplied to the two outer electrodes (10a, 11a) of these n+ 1 electrodes and alternating voltages varying during the integration period between the blocking level and the active level are supplied to the electrodes (10b, c, d) located between these outer electrodes so that the surface parts below these electrodes are alternately brought into inversion and into depletion.

4. A method as claimed in Claim 3, characterized in that in the integration period in which a charge packet is stored in said sensor element the voltages at the inner electrodes of said storage site are periodically varied in the period coinciding with the line fly-back time (Tl) lying between steps of reading out two successive lines.

5. A method as claimed in Claim 4, characterized in that during the line fly-back time the number of the inner electrodes to which the active voltage level is applied is at least temporarily lower than in the period between two line fly-back times, as a result of which the area of the potential well is reduced temporarily, and in that draining means are provided, via which with this reduction of the potential well any excess quantity of charge carriers can be drained.

**Patentansprüche**

1. Verfahren zum Betreiben eines ladungsgekoppelten Bildsensors vom "vergrahener-Kanal"-Typ mit einem Halbleiterkörper mit einer Vielzahl von Ladungstransportkanälen (5, 8) des einen Leitungstyps, die nebeneinander und in der Nähe einer Oberfläche (18) des Körpers liegen und über pn-Übergänge in eine angrenzende Schicht (7) des dem ersten Leitungstyp entgegengesetzten zweiten Leitungstyps übergehen, wobei eine Reihe durch eine Isolierschicht (9) von der Oberfläche getrennter Elektroden (10-12) vorgesehen ist, wobei die Kanäle zusammen mit den Elektroden ein System aus in Zeilen und Spalten angeordneten Bildsensorelementen bilden, wobei ein Ladungsspeicherplatz der genannten Sensorelemente durch die an die Elektroden angelegten Spannungen bestimmt wird, die in den Kanälen ein Muster (Fig. 4) aus Potentialbarrieren induzieren, welche Potentialmulden voneinander trennen, in denen während einer Integrationsperiode (Ta-Tb) durch Suahlungsabsorption erzeugte Ladungsträger zu Laslungspaketen integriert werden, wobei die genannten Spannungen so gewählt werden, daß bei den Potentialbarrieren an der Oberfläche des Halbleiterkörpers Inversion des Leitungstyps auftritt, dadurch gekennzeichnet. daß während einer Integrationsperiode an die den Ladungsspeicherplätzen entsprechende Elektroden Wechselspannungen angelegt werden, so daß zu einem bestimmten Zeitpunkt der Integrationsperiode in jedem Ladungsspeicherplatz die Oberfläche teilweise in den Verarmungszustand und teilweise in den Inversionszustand gebracht wird.

2. Verfahren nach Anspruch 1, dadurch gekennzeichnet, daß an die Elektroden Spannungen mit zwei Pegeln angelegt werden, einem sperrenden Pegel zum Induzieren einer Potentialbarriere in den Kanälen und einem aktiven Pegel zum Induzieren einer Potentialmulde in den Kanälen, wobei die Inversion des Leitungstyps beim Sperrspannungspegel an den Elektroden induziert wird.

3. Verfahren nach Anspruch 2, bei dem die Elektroden mindestens eine Gruppe aus n+1 aufeinanderfolgenden Elektroden (10a, b, c, d; 11a) aufweisen, mit n > 3, die zusammen ein Ladungssensorelement in einem Ladungstransportkanal definieren, dadurch gekennzeichnet, daß während einer Integrationsperiode, in der ein Ladungspaket in dem genannten Sensorelement gespeichert wird, den beiden äußeren (10a, 11a) dieser n+1 Elektroden der sperrende Pegel zugeführt wird und den Elektroden (10b, c, d), die zwischen diesen äußeren Elektroden liegen, Wechselspannungen zugeführt werden, die während der Integrationsperiode zwischen dem sperrenden und dem aktiven Pegel variieren, so daß die Oberflächenteile unter diesen Elektroden abwechselnd in den Inversionszustand und in den Verarmungszustand gebracht werden.

4.  Verfahren nach Anspruch 3, <u>dadurch gekennzeichnet</u>, daß in der Integrationsperiode, in der ein Ladungspaket in dem genannten Sensorelement gespeichert ist, die Spannungen an den inneren Elektroden dieses Speicherplatzes in der Periode, die mit der Zeilen-Rücklaufzeit (T1) zwischen Schritten des Auslesens zweier aufeinanderfolgender Zeilen zusammenfällt, periodisch geändert werden.

5.  Verfahren nach Anspruch 4, <u>dadurch gekennzeichnet</u>, daß während der Zeilen-Rücklaufzeit die Anzahl der inneren Elektroden, an die der aktive Spannungspegel angelegt wird, wenigstens vorübergehend niedriger ist als in der Periode zwischen zwei Zeilen-Rücklaufzeiten, wodurch die Fläche der Potentialmulde vorübergehend verringert wird, und daß Abfuhrmittel vorhanden sind, über die bei dieser Verkleinerung der Potentialmulde ein etwaiger Überschuß an Ladungstägern abgeführt werden kann.

**Revendications**

1.  Procédé de fonctionnement d'un capteur d'image à couplage de charges du type à canal enterré, comprenant un corps semiconducteur présentant plusieurs canaux de transport de charge (5, 8) d'un type de conductivité qui se situent les uns à côté des autres et près d'une surface (18) du corps et passent par l'intermédiaire de jonctions pn à une couche voisine (7) du deuxième type de conductivité opposé au premier type de conductivité, une série d'électrodes (10 - 12) étant prévues qui sont séparées de la surface par une couche isolante (9), lesdits canaux constituant ensemble avec les électrodes un système d'éléments capteurs d'image montés en lignes et en colonnes, un endroit de stockage de charge desdits éléments capteurs étant déterminé par les tensions qui sont appliquées aux électrodes et qui induisent dans les canaux une configuration (figure 4) de puits de potentiel séparant des barrières de potentiel dans lesquels, pendant une période d'intégration (Ta-Tb) des porteurs de charge, engendrés par absorption de rayonnement, sont intégrés dans des paquets de charge, lesdites tensions étant choisies de façon qu'aux barrières de potentiel se produise l'inversion du type de conductivité à la surface du corps semiconducteur, caractérisé en ce que lors d'une période d'intégration, des tensions alternatives sont appliquées aux électrodes correspondant aux endroits de stockage de charge de façon qu'à un certain moment dans la période d'intégration, à chaque endroit de stockage de charge, la surface soit partiellement portée à déplétion et partiellement à inversion.

2.  Procédé selon la revendication 1, caractérisé en ce que des tensions sont délivrées aux électrodes présentant deux niveaux, un niveau de blocage pour induire une barrière de potentiel dans les canaux et un niveau actif pour induire un puits de potentiel dans les canaux, l'inversion du type de conductivité étant induite au niveau de tension de blocage aux électrodes.

3.  Procédé selon la revendication 2, selon lequel les électrodes comprennent au moins un groupe de n + 1 électrodes successives (10a, b, c, d; 11a) avec n > 3, qui définissent ensemble un élément capteur de charge dans un canal de transport de charge, caractérisé en ce que lors d'une période d'intégration dans laquelle un paquet de charte est stocké dans ledit élément capteur le niveau de blocage est délivré aux deux électrodes extrêmes (10a, 11a) de ces n + 1 électrodes et des tensions alternatives variant pendant la période d'intégration entre le niveau de blocage et le niveau actif sont délivrées aux électrodes (10b, c, d) situées entre ces électrodes extrêmes de façon que les parties de surface situées au-dessous des électrodes sont alternativement perdre en inversion et en déplétion.

4.  Procédé selon la revendication 3, caractérisé en ce que la période d'intégration pendant laquelle un paquet de charge est stocké dans ledit élément capteur, les tensions aux électrodes intérieures dudit endroit de stockage sont périodiquement variées dans les périodes coïncidant avec le temps de retour de ligne (T) situé entre des étapes de lecture de deux lignes successives.

5.  Procédé selon la revendication 4, caractérisé en ce que lors du temps de retour de ligne, le nombre des électrodes intérieures auxquelles est appliqué le niveau de tension actif est au moins temporairement inférieur à celui dans la période comprise entre deux temps de retour de ligne, de sorte que la zone du puits de potentiel est réduite temporairement et en ce que des moyens d'évacuation sont prévus par l'intermédiaire desquels à cette réduction du puits de potentiel, toute quantité excédentaire de porteurs de charge peut être évacuée.

FIG.1

FIG.2

FIG.3

FIG.4

FIG.5

FIG.6